Europäisches Patentamt

(19) European Patent Office

Office européen des brevets

(11) Publication number : **0 445 937 A2**

(12) # EUROPEAN PATENT APPLICATION

(21) Application number : **91301410.6**

(22) Date of filing : **21.02.91**

(51) Int. Cl.⁵ : **G11C 19/00, G11C 19/28**

(30) Priority : **06.03.90 JP 54785/90**

(43) Date of publication of application :
**11.09.91 Bulletin 91/37**

(84) Designated Contracting States :
**AT BE CH DE DK ES FR GB GR IT LI LU NL SE**

(71) Applicant : **ADVANCED MICRO DEVICES, INC.**
**901 Thompson Place P.O. Box 3453**
**Sunnyvale, CA 94088 (US)**

(72) Inventor : **Yanai, Akihiro**
**"Park-side I", Room No. 202, 25-6**
**Higashinaruse**
**Isehara-shi, Kanagawa-ken (JP)**

(74) Representative : **Wright, Hugh Ronald et al**
**Brookes & Martin 52/54 High Holborn**
**London WC1V 6SE (GB)**

(54) **Delay circuit.**

(57) Disclosed here are D-type flipflops cascaded in a semicustom LSI such as a standard cell or a gate array. Clock signals supplied to each of the flipflops have phases different from each other due to clock skew. A signal indicative of a data signal holding in the flipflop in one stage is applied to the flipflop in the preceding stage. The flipflop in the preceding stage is responsive to the applied signal for allowing a data signal held in a master latch to be transmitted to a slave latch. As a result, the passing through of data which might be possibly caused by the clock skew can be prevented. In other words, the passing of a data signal through two flipflops during one clock cycle can be prevented.

EP 0 445 937 A2

## DELAY CIRCUIT

The invention relates generally to delay circuits and we will describe a delay circuit for delaying the supplied signal in response to the clock signal with high reliability.

In the design of semi-customized LSI such as standard cells and gate arrays, computer aided design (hereinafter referred to as "CAD") is widely used. For example, a circuit block cell having standard features is previously prepared to be previously registered in a library under the standard cell method. With the CAD system, the desired circuit block cells are automatically arranged and wired in accordance with an automatic arrangement wiring program. In the execution of the automatic arrangement wiring program, the area for arrangement of the wiring is used as effectively as possible to minimize the occupying area of the circuit. As a result, it is seldom that the length of the wiring is designed to be minimum.

However, the delay caused by the wiring for connecting elements has recently evolved into a problem that cannot be ignored as the rapid operation of semiconductor integrated circuits advances. Under such a circumstance, the problem set forth hereinafter occurs when more than one master slave type flipflops are cascaded. In the following description, a delay type (hereinafter referred to as "D-type") flipflop is adopted as an example of a master slave type flipflop.

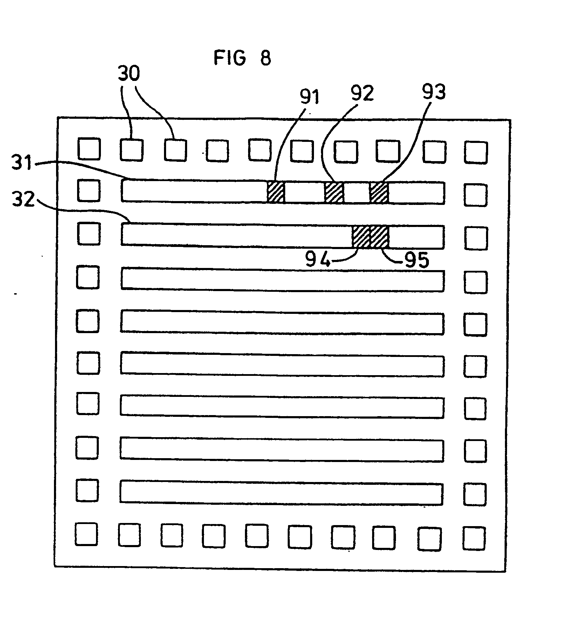

Figure 8 is a simplified block diagram of a gate array. Referring to Figure 8, the gate array comprises an input/output pad 30 for externally inputting/outputting signals, and base cell columns 31 and 32. Five D-Type flipflops 91-95 are implemented using the base cell column. The five flipflops 91-95 are connected in cascade to each other by a wiring (not shown) to construct a shift register having five stages. The wiring path to interconnect each of the flipflops is determined by carrying out the automatic arrangement wiring program provided within the CAD system.

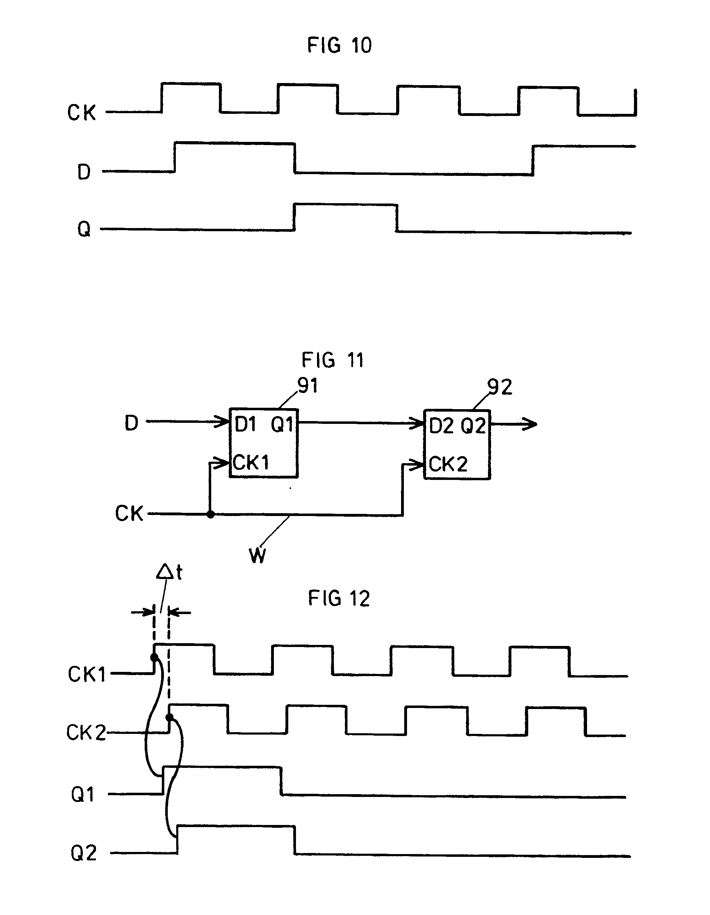

Figure 9 is a circuit diagram of a conventional D-Type flipflop. A D-Type flipflop has the most simple circuit configuration among the numerous master slave type flipflops. Referring to Figure 9, the D-type flipflop comprises inverters 2 and 3 forming the master latch, and inverters 6 and 7 forming the slave latch. A PMOS transistor 1 is connected for the purpose of input control of the master latch. For the output control of the master latch, a NMOS transistor 4 is connected. Transistors 1 and 4 operate in response to clock signal CK. Data D applied to the D-type flipflop is provided as the output data Q with a delay defined by the frequency of the clock signal CK.

Figure 10 is a timing diagram for explaining the operation of the circuit shown in Figure 9. In operation, input data D is sampled and held in the master latch formed by inverters 2 and 3 in response to the rise of the clock signal CK. Since the transistor 4 is turned on in response to the high level of the clock signal CK, the data signal held within the master latch is provided to the slave latch formed by inverters 6 and 7. As a result, the output data signal Q is provided via the slave latch.

Figure 11 is a circuit diagram showing the circuit connection when two D-type flipflops are cascaded. Figure 12 is a timing diagram for explaining the operation. It should be noted in Figure 12 that the clock signal CK2 applied to the flipflop 92 is delayed by $\Delta t$ with respect to the clock signal CK1 applied to flipflop 91 by clock skew. This delay time $\Delta t$ may be caused by arranging and wiring the two flipflops 91 and 92 in accordance with the automatic arrangement wiring program of the above mentioned CAD system. That is, the flipflop 92 is connected so as to receive the clock signal CK via a wiring W longer than the flipflop 91 to cause the delay time $\Delta t$ called clock skew

As shown in Figure 12, the flipflop 91 establishes an output data signal Q1 in response to the rise of the clock signal CK1. In the embodiment, a high level data signal Q1 is provided. When data signal Q1 rises, the clock signal CK2 is not yet raised because the clock signal CK2 is delayed. This causes the data signal Q1 to be sampled in the flipflop 92 when the clock signal CK2 rises. As a result, the data signal Q1 from the flipflop 91 is provided as the data signal Q2 from the flipflop 92 in response to the same rise of the clock signal CK2. In other words, data D passes through two flipflops 91 and 92 within one clock period, i.e., the "passing through of data" is occurring. This means that the desired delaying operation by two D-type flipflops 91 and 92 is suppressed to become the direct cause of malfunction of the circuit comprising these flipflops.

The delay circuit in accordance with the present invention comprises first and second cascaded holding means each responsive to clock signals for holding applied data signals, signal line means for supplying the clock signal applied to the first holding means to the second holding means with some delay, and transmitting means for transmitting the data signal held in the first holding means to the second holding means.

In the delay circuit of an embodiment of the present invention, since the transmitting means supplies the data signal held in the first holding means to the second holding means in response to the holding of the second holding means, the passing through of the data signal is prevented even when the timing of the clock signal applied to each of the first and second holding means deviates from each other.

**Brief Description of the Drawings**

Figure 1 is a circuit diagram of D-type flipflops showing an embodiment of the present invention,

Figure 2 is a circuit diagram of the D-type flipflop shown in Figure 1,

Figure 3 is a timing diagram for explaining the operation of the circuit shown in Figure 2,

Figure 4 is a block diagram of the circuit shown in Figure 1,

Figure 5 is a timing diagram for explaining the operation of the circuit shown in Figure 1,

Figure 6 is a wiring block diagram of an application of the present invention to standard cells,

Figure 7 is a circuit diagram showing an embodiment of an application of the present invention to a JK flipflop,

Figure 8 already referred to is a block diagram of a simplified gate array.

Figure 9 already referred to is a circuit diagram of a conventional D-type flipflop,

Figure 10 already referred to is a timing diagram for explaining the operation of the circuit shown in Figure 9,

Figure 11 already referred to is a circuit diagram showing the circuit connection of conventional cascaded D-type flipflop, and

Figure 12 already referred to is a timing diagram for explaining the operation of the circuit shown in Figure 11.

In the drawings, 1 is a PMOS transistor, 2, 3, 6, 7 are inverters, 4 and 5 are NMOS transistors.

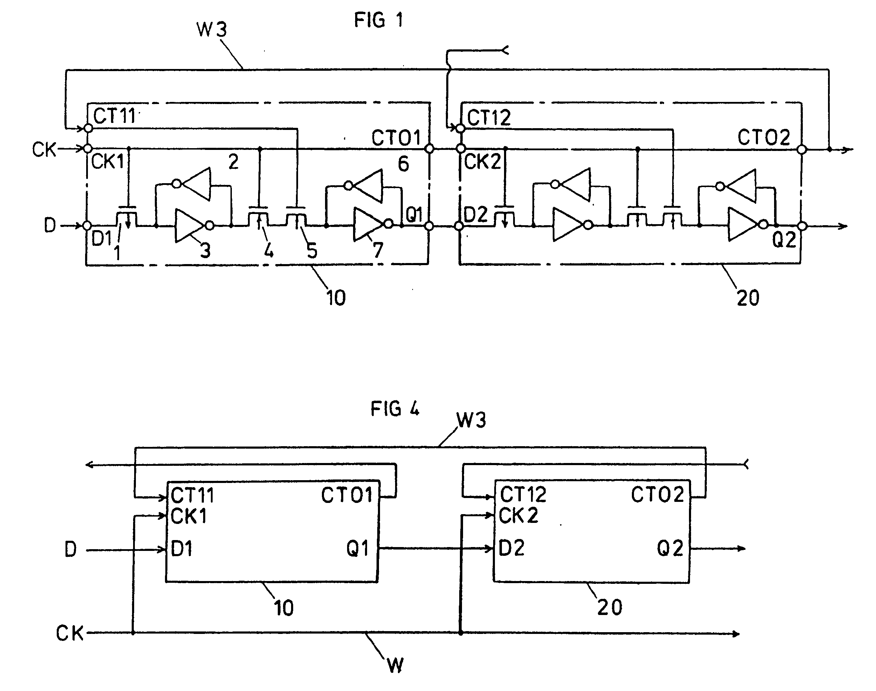

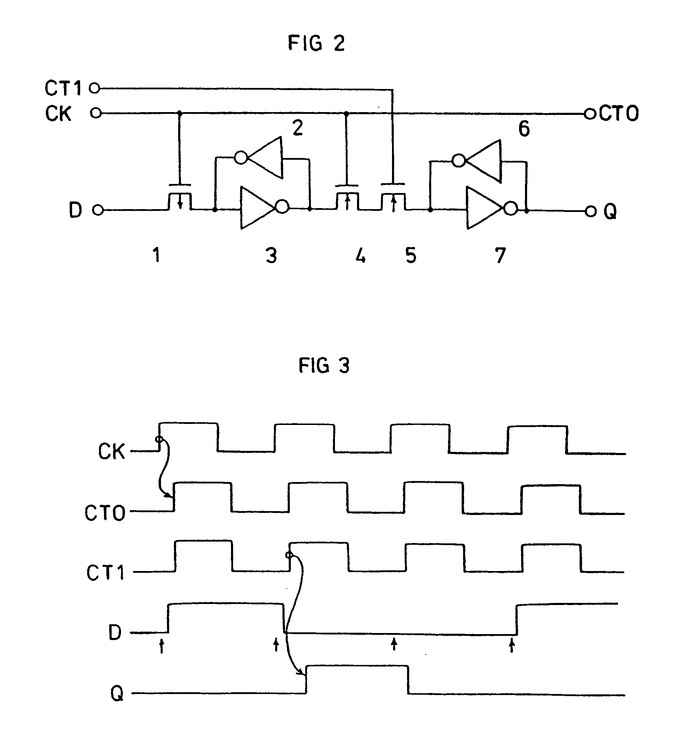

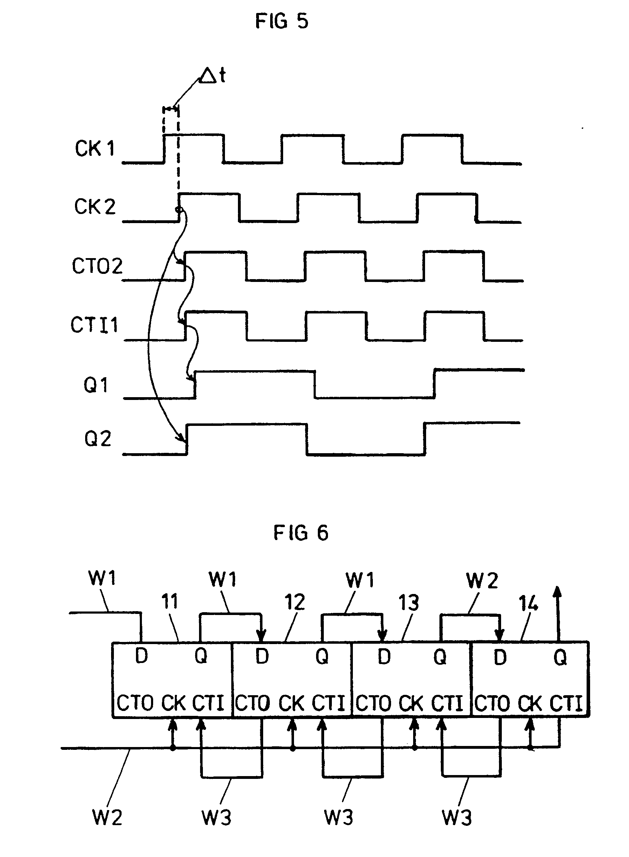

Figure 1 is a circuit diagram of a cascaded D-type flipflop showing an embodiment of the invention. Referring to Figure 1, flipflops 10 and 20 having the same circuit configuration of the D-type flipflop shown in Figure 2 are cascaded. Flipflop 10 is connected so as to receive the clock signal transmitted via the flipflop 20 i.e., to receive the signal CTO2 as the signal CTI1 via the wiring W3. This causes the transistor 5 in flipflop 10 to be turned on after data is held within the master latch in flipflop 20. The circuit connection of Figure 1 is shown as a block diagram in Figure 4.

Figure 2 is a circuit diagram showing an improved D-type flipflop employed in one embodiment of the invention. The D-type flipflop shown in Figure 2 has a NMOS transistor 5 provided between the transistor 4 and the slave latch in comparison with the conventional flipflop shown in Figure 9. The transistor 5 operates in response to the signal CTI which indicates the holding in the next stage circuit connected to receive the output data signal Q.

Figure 3 is a timing diagram for explaining the operation of the circuit shown in Figure 2. In operation, since the transistor 1 is turned on in response to the rise of the clock signal CK, the input data signal D is held within the master latch formed by the inverters 2 and 3. The transistor 4 is also turned on in response to the rise of the clock signal CK. However, since a transistor 5 is connected between the transistor 4 and the slave latch, the timing of the application of the data signal held in the master latch to the slave latch is controlled by the signal CTI. Therefore, the data signal held in the master latch is applied to the slave latch via transistors 4 and 5 in response to the rise of the signal CTI.

Referring to the timing diagram of Figure 5, the operation of the circuit shown in Figure 1 will be explained. Since the clock signal CK is provided to each flipflop 10 and 20 via the wiring W of Figure 4, the clock signal CK2 provided to the flipflop 20 is delayed by $\Delta t$ with respect to the clock signal CK1 by clock skew. However, the signal CTO2 provided via the flipflop 20 is further delayed than the clock signal CK2. Since the clock signal CTI1 provided to the transistor 5 in flipflop 10 is simultaneous or delayed with respect to the signal CTO2, the rise of the data signal Q1, i.e., the output of the flipflop 10 is provided after the rise of the clock signal CK2. In other words, after the previous data D2 is held within the master latch of the flipflop 20, the transistor 5 of the flipflop 10 is turned on to output the data signal Q1. Consequently, it is understood that the "passing through of data" phenomenon in conventional circuits described in conjunction with Figure 13 may be reliably prevented.

Referring to Figure 6, standard cells 11-14 forming a D-type flipflop are cascaded by wiring W1, W2 and W3. Each wiring W1 connects the input/output of each standard cell 11-14. The wiring W2 provides the clock signals to each standard cell 11-14. Each wiring W3 transmits the signal indicating the holding of the master latch in each later stage flipflop to each prior stage flipflop as signal CTI.

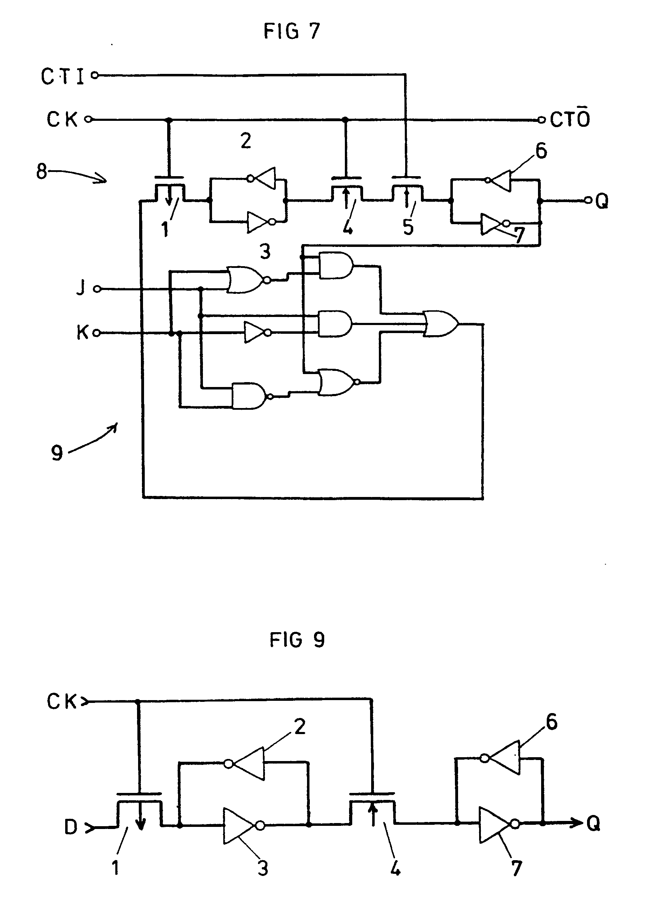

The above described embodiment of the present invention is applied to a D-type flipflop. It is also applicable to a circuit having master slave-type flipflops cascaded. For example, an application of the present invention to a JK flipflop is shown in Figure 7. The JK flipflop comprises a D-type flipflop portion 8 and a logical gate portion 9. The logical gate portion 9 includes a logical circuit necessary to form a JK flipflop.

In accordance with an embodiment of the present invention, transmitting means for transmitting the data signal held in the first holding means to the second holding means in response to the holding of the second holding means is provided to obtain a delay circuit which can reliably delay the applied data signal in response to the clock signal.

**Claims**

1. A delay circuit, comprising
   first and second cascaded holding means each responsive to a clock signal for holding the applied data signals,

each of said first and second holding means being responsive to the clock signal for holding and providing the applied data signal:

signal line means connected between said first and second holding means for supplying the clock signal applied to said first holding means to said second holding means with some delay, and

transmitting means connected between said first and second holding means and responsive to the holding of said second holding means for transmitting the data signal held in said first holding means to said second holding means.

2. A delay circuit according to claim 1, wherein said transmitting means comprises

first switching means connected between said first and second holding means having control input, and

applying means for applying the clock signal provided to said second holding means to the control input of said first switching means, and

said first switching means is operative in response to the applied clock signal.

3. A delay circuit according to claim 2, wherein said first holding means comprises

second switching means connected to receive the data signal operative in response to the applied clock signal, and

first latch means connected to the output of said second switching means for latching the data signal provided from said second switching means,

said first switching means is connected to the output of said first latch means, and

said second holding means comprises

third switching means connected to receive the output signal from said first switching means for operating in response to the clock signal applied via said signal line means, and

second latch means connected to the output of said third switching means for latching the data signals provided from said third switching means.

4. A semiconductor integrated circuit device capable of designing a wiring using an automatic wiring process by Computer Aided Design (CAD) system comprising:

first and second cascaded holding means each responsive to the clock signal for holding the applied data signals,

each of said first and second holding means responsive to the clock signal for holding and providing the applied data signal,

signal line means connected between said first and second holding means for applying the clock signal provided to said first holding means to said second holding means with some delay,

the wiring path of said signal line means being determined by said automatic wiring process, and

transmitting means connected between said first and second holding means and responsive to the holding of said second holding means for transmitting the data signal held in said first holding means to said second holding means.

5. A semiconductor integrated circuit device according to claim 4, wherein said semiconductor integrated circuit device comprises one of a gate array device and a standard cell device.

FIG 1

FIG 4

FIG 2

FIG 3

FIG 5

FIG 6

## FIG 7

## FIG 9

FIG 8

## FIG 10

## FIG 11

## FIG 12